# DEMANDE DE BREVET EUROPEEN

(11) **EP 2 750 166 A1**
(43) Date de publication de la demande: **02.07.2014**
(21) Numéro de dépôt: 13354044.3
(22) Date de dépôt: 05.12.2013
(51) Int. Cl.: H01L 21/20

(54) **Traitement de surface par plasma chloré dans un procédé de collage**

(30) Priorité: 26.12.2012 FR 1203592
(71) Demandeur: COMMISSARIAT A L'ENERGIE ATOMIQUE ET AUX ENERGIES ALTERNATIVES, 75015 Paris (FR)
(72) Inventeur: Agraffeil, Claire, F- 38000 Grenoble (FR)
(74) Mandataire: Talbot, Alexandre

(57) **Abrégé**

Le procédé de collage de deux surfaces à base de silicium comprend les étapes :
- soumettre l'une au moins des surfaces à un traitement d'activation de surface au moyen d'un plasma oxygène comprenant du chlore, le pourcentage de dilution en volume du chlore dans l'oxygène du plasma étant de 0,25 à 10%, préférentiellement 1 à 3%,
- mettre en contact les surfaces traitées.

## Description

### Domaine technique de l'invention

L'invention concerne un procédé de collage direct de deux surfaces à base de silicium.

### État de la technique

Le principe du collage par adhérence moléculaire ou collage direct est basé sur la mise en contact direct de deux surfaces, sans utilisation d'un matériau spécifique tel qu'une colle, une cire, un métal à basse température de fusion, etc.

Les collages directs sont généralement réalisés à température et pression ambiantes, après un nettoyage chimique des surfaces. Cependant, de tels collages présentent de faibles énergies de collage qu'il est souvent nécessaire de renforcer par un traitement thermique ultérieur. Ainsi, pour obtenir des énergies de collage de l'ordre de 5 J/m², il est nécessaire d'avoir recours à un traitement thermique à haute température, typiquement de l'ordre de 1000°C. Or, dans un très grand nombre d'applications, les traitements thermiques à une telle température ne sont pas admissibles.

Des procédés de collage, ne nécessitant pas de traitement thermique à haute température, ont déjà été proposés. Ils comprennent en général une étape d'activation de surface nécessitant des conditions opératoires tout à fait particulières, souvent difficiles à mettre en oeuvre.

À titre d'exemple, U. Gösele et al. (« Selfpropagating roomtemperature silicon wafer bonding in ultrahigh vacuum », Appl. Phys. Lett. 1995, 67 : 3614) ont étudié les effets d'un traitement d'activation de surface du silicium au moyen d'un plasma d'argon. Un tel traitement permet un collage direct de plaques de silicium présentant des énergies de collages élevées. Cependant, un tel procédé nécessite d'être réalisé sous ultra-vide (3.10⁻⁹ Torr). Un équipement spécifique est donc indispensable pour mettre en oeuvre un collage selon U. Gösele et al.

C. Wang et T. Suga (« Room-temperature direct bonding using fluorine containing plasma activation », J. Electrochem. Soc. 2011, 158(5):H529) ont cherché à remédier aux inconvénients des procédés de collage de l'art antérieur. Ils ont ainsi décrit un procédé de collage direct à température et pression ambiantes comprenant une étape d'activation de surface au moyen d'un plasma O₂/CF₄ suivie d'une étape de mise en contact des surfaces traitées. Le procédé d'activation O₂/CF₄ est réalisé dans un réacteur standard de type RIE et permet d'obtenir des énergies de collage élevées entre deux surfaces de silicium. Cependant, ce procédé ne permet pas d'obtenir directement un collage sans défaut et implique au moins deux étapes additionnelles.

Tout d'abord, il est nécessaire une fois les surfaces activées et avant la mise en contact de maintenir les surfaces dans des conditions de température et d'humidité contrôlées afin de préparer le collage. Les substrats sont ainsi disposés sur une plaque chauffante sous atmosphère humide afin d'obtenir un taux d'humidité relative spécifique de la surface du substrat. Après la mise en contact des surfaces, une étape de « rold colling » est également décrite. Cette étape consiste à appliquer une pression sur les deux substrats à coller afin de diminuer le nombre de défauts présents au niveau de l'interface de collage.

### Objet de l'invention

L'invention a pour but un procédé de collage direct de deux surfaces à base de silicium pouvant être mis en oeuvre à température ambiante et permettant d'obtenir une interface de collage substantiellement sans défaut présentant une énergie de collage élevée par rapport aux procédés de l'art antérieur et ce, sans étape additionnelle de traitement thermique ultérieur à haute température, par exemple à une température de l'ordre de 500 voire 1000°C. Le procédé de collage ne nécessite pas non plus une quelconque étape additionnelle de conditionnement des surfaces dans des conditions particulières d'humidité et/ou de température après activation et avant collage ou même une étape de « rold colling » après mise en contact des surfaces.

Selon l'invention, ce but est atteint par le fait, qu'avant la mise en contact des surfaces à base de silicium, l'une au moins desdites surfaces est soumise à un traitement d'activation de surface au moyen d'un plasma oxygène comprenant du chlore, le pourcentage de dilution en volume du chlore dans l'oxygène du plasma étant de 0,25 à 10%, préférentiellement de 1 à 3%.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente le spectre infrarouge d'un collage O₂/CF₄ de deux surfaces à base de silicium selon l'art antérieur sans étape de conditionnement des surfaces contrôlant le taux d'humidité relative des surfaces avant collage ou de cold rolling ;
- la figure 2 représente le spectre infrarouge d'un collage O₂/HBr/Cl₂ de deux surfaces à base de silicium selon un mode particulier de réalisation de l'invention.

### Description de modes particuliers de réalisation

L'invention concerne un procédé de collage direct de deux surfaces à base de silicium, avantageusement réalisé à température ambiante. Le procédé comprend les étapes suivantes successives :
- soumettre au moins l'une des surfaces à un traitement d'activation de surface au moyen d'un plasma oxygène comprenant du chlore, le pourcentage de dilution en volume du chlore dans l'oxygène du plasma étant de 0,25 à 10%, préférentiellement de 1 à 3%,
- mettre en contact les surfaces.

Par « surfaces à base de silicium » on entend des surfaces dont l'un des constituants, généralement majoritaire, est le silicium. Lesdites surfaces sont préférentiellement choisies parmi les surfaces en silicium, oxydes de silicium, silicium-germanium, oxycarbure de silicium et nitrure de silicium. Elles présentent une rugosité typiquement inférieure au nanomètre, préférentiellement inférieure à 0,5 nm, plus préférentiellement encore comprise entre 0,15 et 0,5 nm. Les valeurs de rugosité sont mesurées par pointe AFM sur des champs de 1µm x 1µm.

Par « température ambiante », on entend une température de 25 ± 5°c. Par « pression ambiante », on entend une pression d'environ 1013,25 hPa.

La surface à base de silicium peut être obtenue par tout moyen connu de l'homme du métier. Le silicium peut être sous forme amorphe, monocristalline ou polycristalline. Selon un mode de réalisation, le dépôt du matériau formant la surface à base de silicium peut se faire par PECVD (Plasma-enhanced chemical vapor deposition) ou par PVD (Physical vapor deposition) sur un substrat adapté. Avantageusement, le substrat est en LiNbO₃ ou en quartz.

Le procédé de collage comprend au moins un traitement d'activation consistant à exposer l'une au moins des deux surfaces à un plasma oxygène comprenant du chlore. Par plasma oxygène, on entend un plasma comprenant au moins 75%, préférentiellement 80%, plus préférentiellement 90% et plus préférentiellement encore 95% en volume d'oxygène. D'autres gaz que l'oxygène peuvent être présents dans le plasma oxygène en faibles quantités, c'est-à-dire à une concentration de l'ordre de quelques pourcents en volume et, plus particulièrement, inférieure à 5%. Le pourcentage de dilution en volume du chlore dans l'oxygène du plasma est de 0,25 à 10%, préférentiellement de 1 à 3%. Le chlore peut être apporté sous différentes formes. Il peut s'agir notamment de tout composé choisi parmi Cl₂, BCl₃, HCl, SiCl₄ et leurs mélanges. Le pourcentage de dilution est mesuré en comparant le volume du précurseur chloré considéré comme pur par rapport au volume de précurseur oxygéné.

Le traitement d'activation de surface des surfaces à base de silicium permet de créer, à la surface des substrats, une couche superficielle d'oxyde de silicium contenant du chlore. Avantageusement, la couche superficielle d'oxyde de silicium contenant du chlore présente une épaisseur comprise entre 1 et 5 nm.

La couche superficielle d'oxyde de silicium contenant du chlore obtenue grâce au traitement d'activation de surface présente la propriété d'être hydrophile. Elle présente typiquement un angle de mouillage pour une goutte d'eau inférieure à 25°, préférentiellement comprise entre 15 et 20°.

Selon un mode de réalisation particulier, le plasma du traitement d'activation de surface comprend, outre de l'oxygène et du chlore, du brome, de l'argon, de l'azote, du fluor ou un mélange de ceux-ci. Le plasma peut donc être constitué d'oxygène et de chlore. Il peut également être constitué d'oxygène, de chlore et de brome. Il peut encore être constitué d'oxygène et de chlore et d'au moins un des constituants choisis parmi l'argon, le brome, l'azote et le fluor.

Selon un mode de réalisation préféré, notamment lorsque les surfaces à coller sont à base d'oxyde de silicium, plus particulièrement à base de SiO₂, le plasma du traitement d'activation de surface comprend de l'oxygène, du chlore et du brome, le pourcentage de dilution en volume du brome dans l'oxygène du plasma est de 0,25 à 10%, préférentiellement de 2 à 5%. Le brome est préférentiellement apporté sous la forme de HBr. Le pourcentage de dilution en volume du brome dans l'oxygène du plasma est mesuré en comparant le volume du précurseur bromé considéré comme pur par rapport au volume de précurseur oxygéné.

Selon un mode de réalisation particulier, le traitement d'activation de surface est réalisé à une pression de 5 à 200 mT, préférentiellement de 30 à 80 mT, plus préférentiellement encore de 50 à 70 mT.

Selon un mode de réalisation compatible avec les modes précédents, le plasma du traitement d'activation de surface est généré par une source d'une puissance de 200 à 1000 W, préférentiellement de 300 à 500 W.

Avantageusement, la durée du traitement d'activation de surface est comprise entre 10 et 120 secondes, préférentiellement entre 20 et 40 secondes.

Selon un mode de réalisation particulièrement préféré, le plasma du traitement d'activation de surface est généré par une source d'une puissance de 200 à 1000 W, préférentiellement de 300 à 500 W, ledit traitement présentant une durée comprise entre 10 et 120 secondes, préférentiellement comprise entre 20 et 40 secondes.

Suite au traitement d'activation de surface, les surfaces traitées sont mises en contact, par exemple manuellement, à température et pression ambiantes. Une légère pression localisée peut être appliquée par exemple à l'aide d'un stylet pour initier le collage. L'onde de collage se propage ensuite de façon spontanée et homogène à l'ensemble de la structure assemblée formant une interface de collage substantiellement sans défaut et ceci, sans qu'il soit nécessaire d'appliquer une quelconque pression supplémentaire.

Selon un mode de réalisation et préalablement au traitement d'activation de surface, au moins une surface à base de silicium est soumise à un traitement d'oxydation de surface au moyen d'un plasma oxygène dépourvu de chlore. Le traitement d'oxydation génère en surface de la couche à base de silicium un oxyde de silicium de l'ordre de 0,25 à 10 nm d'épaisseur, typiquement entre 1 et 5 nm d'épaisseur. L'oxyde de silicium a notamment pour rôle la protection de la surface à base de silicium en vue de l'étape ultérieure d'activation, ceci notamment lorsque le plasma contient une quantité élevée de chlore. En effet, dans certaines conditions, le chlore, lorsqu'il est présent en grande quantité, notamment si son pourcentage est supérieur à 1% en volume dans l'oxygène du plasma, peut altérer la surface à base de silicium en gravant le silicium présent.

Selon un mode de réalisation particulier, le traitement d'oxydation de surface est réalisé à une pression de 5 à 200 mT, préférentiellement de 30 à 80 mT, plus préférentiellement encore de 50 à 70 mT.

Selon un mode de réalisation compatible avec les modes précédents, le plasma du traitement d'oxydation de surface est généré par une source d'une puissance de 200 à 1000 W, préférentiellement de 300 à 500 W.

Avantageusement, la durée du traitement d'oxydation de surface est comprise entre 5 et 60 secondes, préférentiellement entre 20 et 40 secondes.

Selon un mode de réalisation particulièrement préféré, le plasma du traitement d'oxydation de surface est généré par une source d'une puissance de 200 à 1000 W, préférentiellement de 300 à 500 W, ledit traitement présentant une durée comprise entre 5 et 60 secondes, préférentiellement entre 20 et 40 secondes.

Les plasmas des traitements de surface sont générés par tout moyen connu de l'homme du métier. Avantageusement, ils sont générés par une source plasma à couplage inductif (ICP ou Inductively Coupled Plasma) ou à couplage capacitif (RIE ou Reactif Ion Etching).

Lors du traitement d'activation, seule une des deux surfaces peut être traitées. Lorsque les deux sont traitées, les surfaces peuvent être exposées simultanément ou successivement au plasma oxygène comprenant du chlore. Dans le cas d'expositions successives, les conditions du traitement de surface subi par les deux surfaces peuvent être les mêmes ou différentes. De plus, l'exposition du ou des substrats au plasma peut être réalisée en une ou plusieurs fois.

De même, lors du traitement d'oxydation, seule une des deux surfaces peut être traitées. Si les deux sont traitées, les surfaces peuvent être exposées simultanément ou successivement au plasma oxygène. Dans le cas d'expositions successives, les conditions du traitement de surface subi par les deux surfaces peuvent être les mêmes ou différentes. De plus, l'exposition du ou des substrats au plasma peut être réalisée en une ou plusieurs fois.

Dans un mode spécifique de réalisation, des couches superficielles d'oxyde sont formées à la surface des surfaces à base de silicium par voie humide et en particulier par une étape de nettoyage par voie humide. Ainsi, préalablement à toute étape de traitement de surface, les surfaces sont avantageusement soumises à une étape de nettoyage. Préférentiellement, l'étape de nettoyage est une étape de type CARO suivi d'un nettoyage de type RCA comprenant une première phase de type SC1 et une seconde phase de type SC2. Le nettoyage de type CARO est un nettoyage dans un bain d'acide appelé CARO (H₂SO₄ + H₂O₂). La première phase (SC1 ou « Standard Cleaning 1 ») et la seconde phase (SC2 ou « Standard Cleaning 2 ») du nettoyage de type RCA consistent, respectivement, en un nettoyage à l'aide d'une solution alcaline telle que NH₄OH + H₂O₂ + H₂O et en un nettoyage à l'aide d'un agent oxydant puissant tel que HCl + H₂O₂ + H₂O. Les surfaces ainsi nettoyées présentent l'avantage d'avoir une faible quantité de défauts après collage.

Cependant, au moins une couche superficielle d'oxyde peut être formée, préalablement au traitement d'activation de surface, par d'autres techniques, seules ou en combinaison. Elle peut, par exemple, être formée par oxydation thermique. Elle peut également être formée par dépôt tel qu'un dépôt chimique en phase vapeur (CVD), un dépôt par pulvérisation par faisceau d'ions (IBS) ou par oxydation directe de la surface de silicium par ICP ou RIE.

L'étape de traitement d'activation de surface permettant l'obtention de surfaces à base de silicium hydrophiles est suivie par une étape de mise en contact des surfaces hydrophiles. L'étape de mise en contact peut être réalisée in situ, c'est-à-dire dans l'enceinte où est réalisé le ou les traitements de surface. Elle est plus généralement réalisée ex-situ. De plus, la mise en contact des surfaces peut être réalisée directement après l'étape d'activation de surface, c'est-à-dire sans étape intermédiaire entre les deux étapes d'activation de surface et de mise en contact. Dans des variantes de réalisation, une ou plusieurs étapes intermédiaires peuvent être réalisées entre ces deux étapes, par exemple pour enlever les particules ou une éventuelle contamination (métallique ou hyrocarbure...) déposées lors de l'étape d'activation de surface. Ces étapes intermédiaires peuvent, par exemple, comprendre des étapes de traitements de surface, chimiques ou classiquement utilisés dans le domaine de la microélectronique, par exemple un ou plusieurs brossages.

Dans tous les cas, les étapes additionnelles, également notées étapes intermédiaires, sont réalisées de manière à conserver le caractère hydrophile des surfaces ayant été soumises au traitement d'oxydation et/ou au traitement d'activation.

Selon un mode particulier de réalisation, une étape de traitement thermique à une température de 80 à 200°C, préférentiellement de 80 à 120°C est réalisée après l'étape de mise en contact des surfaces activées. Avantageusement, l'étape de traitement thermique est réalisée pendant une durée de 30 à 120 minutes, préférentiellement de 45 minutes à 75 minutes. Une telle étape permet d'obtenir plus rapidement une même énergie de collage entre les surfaces à base de silicium. En effet, une même énergie peut être obtenue à pression et température ambiantes après typiquement 24 heures.

Dans tous les cas, une fois que les surfaces activées au moyen d'un plasma oxygène comprenant du chlore sont mises en contact, l'interface de collage présente un nombre de défauts considérablement réduit par rapport aux procédés de collage selon l'art antérieur, voire sans défaut. En particulier, elle ne comporte pas de bulle. De plus, cette interface reste de bonne qualité dans le temps, même lorsque la structure collée subit une étape ultérieure de traitement thermique.

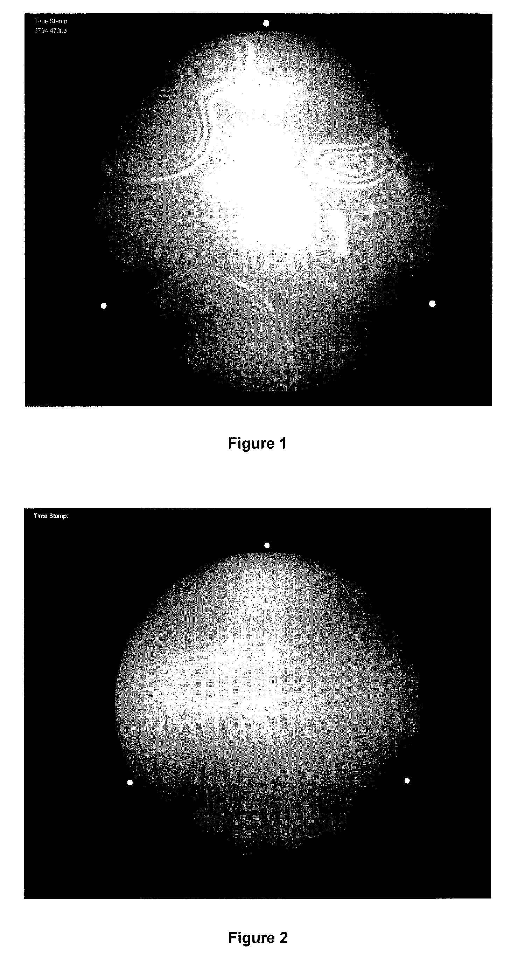

A titre d'exemple, la figure 1 représente le spectre réalisé par spectroscopie infrarouge à transformée de Fourrier (FTIR) d'un collage O₂/CF₄ de deux surfaces à base de silicium selon le mode opératoire décrit par C. Wang et T. Suga (« Investigation of fluorine containing plasma activation for room-temperature bonding of Si-based materials», Microelectronics Reliability 2012, 52:347) mais sans étape préalable de conditionnement du taux d'humidité des surfaces avant collage. Le spectre infrarouge illustré est réalisé directement après l'étape de mise en contact sans que cette étape ne soit suivie d'une étape de cold rolling. La figure 2 représente le spectre infrarouge (FTIR) d'un collage O₂/HBr/Cl₂ de deux surfaces à base de silicium selon un mode de réalisation de l'invention décrit ci-après. Le spectre infrarouge est également réalisé directement après l'étape de collage. Contrairement, au collage selon l'art antérieur, le collage direct après un traitement d'activation de surface au moyen d'un plasma oxygène comprenant du chlore permet d'obtenir une interface de collage substantiellement sans défaut.

Outre une interface de collage substantiellement sans défaut, le procédé de collage selon l'invention permet d'obtenir des énergies de collage élevées, c'est-à-dire supérieures à 3 voire 5 J/m². La mesure de l'énergie de collage est évaluée selon la méthode décrite par C. Wang et T. Suga (« Room-temperature direct bonding using fluorine containing plasma activation », J. Electrochem. Soc. 2011, 158(5):H529).

Le procédé de collage selon l'invention peut, avantageusement, être appliqué au collage de plaques comportant une surface libre à base de silicium, lesdites plaques comprenant un dispositif sensible aux traitements thermiques. Le procédé peut également avantageusement permettre le collage d'hétérostructures dont les coefficients de dilatation thermique (CTE) sont très différents. A titre d'exemples d'hétérostructures à CTE différents, le procédé permet de réaliser des collages LiNbO₃/silicium, quartz/silicium présentant des énergies de collage très fortes (4 à 5 J/m²) à température ambiante. Dans de tels cas, une couche de SiO₂ est déposée sur les substrats de LiNbO₃ ou de quartz. Préférentiellement, le dépôt est réalisé par PECVD formant ainsi une surface à base de silicium sur les substrats. Lesdites surfaces en SiO₂ présentent avantageusement une épaisseur de 200 nm.

De la même manière, le procédé de collage permet de réaliser des collages d'hétérostructures comportant des polymères particulièrement sensibles à la chaleur. Dans un tel cas, le dépôt de la surface à base de silicium est avantageusement réalisé sur le substrat à basse température (compatible avec le polymère) par PVD.

D'autres caractéristiques et avantages apparaîtront à la lecture des exemples non limitatifs décrits ci-après.

### Exemples

À titre d'illustration, des essais ont été réalisés avec des substrats comprenant une surface à base de silicium. Les substrats présentent une épaisseur de 750 microns et un diamètre de 200 mm. Ainsi, les exemples 1 à 6 correspondent chacun à un procédé de collage entre deux substrats ayant chacun été soumis à un nettoyage et à une exposition dans un plasma oxygène comprenant du chlore, dans des conditions diverses, avant leur mise en contact. Avant l'étape d'activation plasma, tous les substrats ont été nettoyés avec un nettoyage de type CARO, puis de type RCA (SC1 et SC2).

L'enceinte dans laquelle est réalisé le traitement de surface pour les exemples 1 à 6 est un dispositif ICP commercialisé par la société Applied Materials sous le nom AMAT Centura DPS+.

### Exemple 1 : Procédé de collage de différentes surfaces à base de silicium

Trois types de collage ont été réalisés selon la composition des surfaces à base de silicium à coller : le collage de deux surfaces en silicium (Si/Si), celui de deux surfaces en SiO₂ (SiO₂/SiO₂), celui d'une première surface en silicium avec une seconde surface en SiO₂ (Si/ SiO₂).

Les conditions opératoires pour réaliser le procédé de collage sont les suivantes :
- Les substrats comportant une surface à base de silicium de 145 nm d'épaisseur sont introduits dans une enceinte ICP dont la source plasma à couplage inductif comprend un générateur de puissance radiofréquences dont la puissance peut être de quelques centaines de watts et préférentiellement entre 500 W et 800W.
- Le traitement d'oxydation de surface est réalisé à température ambiante, c'est-à-dire à 25 ± 5°C, sous une pression partielle de 60mT pendant une durée de 30 secondes. La puissance de la source plasma est fixée à 800 W tandis que la puissance du bias est fixée à 20 W. Le plasma est un plasma oxygène pur (débit : 100 sccm).
- Le traitement d'oxydation est directement suivi d'un traitement d'activation de surface. Le traitement d'activation est réalisé à température ambiante, c'est-à-dire à 25 ± 5°C, sous une pression partielle de 60mT pendant une durée de 30 secondes. La puissance de la source plasma est fixée à 400 W tandis que la puissance du bias est fixée à 10 W. Le plasma est un plasma O₂ (100 sccm) / Cl₂ (3 sccm). Le pourcentage de dilution en volume du chlore dans l'oxygène du plasma est de 3%.
- Les substrats traités sont mis en contact manuellement puis stockés dans des conditions standard durant quelques heures (25 ± 5°C, pression atmosphérique, 30 à 60% d'humidité relative).

Les énergies de collage sont évaluées selon la méthode décrite par C. Wang et T. Suga (« Room-temperature direct bonding using fluorine containing plasma activation », J. Electrochem. Soc. 2011, 158(5):H529) après 12, 24, 35, 45 et 55h de stockage. Les résultats obtenus sont présentés dans le tableau 1.

**Tableau 1**

| Durée de stockage (h) | | 12 | 24 | 36 | 48 |
|---|---|---|---|---|---|
| Energie de collage (J/m²) | Si/Si | 2,9 | 3,6 | 5 | 5 |
| | SiO₂/SiO₂ | 1,9 | 2,3 | 3,6 | 3,6 |
| | Si/SiO₂ | 3,2 | 4,1 | 4,6 | 4,6 |

Après un stockage de 36h, tous les collages présentent des énergies de collage élevées, c'est-à-dire supérieures à 3 voire 4 J/m².

### Exemple 2 : Procédé de collage comportant ou non un traitement d'oxydation de surface au moyen d'un plasma oxygène dépourvu de chlore

Les collages sont réalisés entre deux surfaces en SiO₂ (SiO₂/SiO₂) de 145 nm d'épaisseur. Un premier collage est réalisé, comme à l'exemple 1, avec un traitement d'oxydation de surface suivi d'un traitement d'activation de surface et d'une mise en contact directe des surfaces traitées. Un second collage est réalisé sans traitement d'oxydation de surface, l'étape de nettoyage étant immédiatement suivie d'un traitement d'activation de surface et d'une mise en contact direct des surfaces traitées.

Les conditions opératoires sont les mêmes que celles de l'exemple 1 à l'exception de la pression à l'intérieur de l'enceinte lors de la ou des étapes de traitement de surface qui est de 40 mT, soit environ 0,1333 mPa.

Les résultats obtenus sont présentés dans le tableau 2.

**Tableau 2**

| Durée de stockage (h) | | 12 | 24 | 36 | 48 |
|---|---|---|---|---|---|
| SiO₂/SiO₂ | Avec traitement d'oxydation de surface | 1,9 | 2,3 | 3,6 | 3,6 |
| | Sans traitement d'oxydation de surface | 1,2 | 1,3 | 1,3 | 1,5 |

Dans le cas du collage SiO2//SiO2 et pour une pression de 40 mT, l'ajout d'une phase d'oxydation préalable par plasma O₂ permet d'atteindre de plus haute valeur d'énergie de collage que l'activation en plasma O₂/Cl₂ seule.

### Exemple 3 : Procédé de collage de surfaces en silicium en fonction de la pression lors des traitements de surfaces

Les collages sont réalisés entre deux surfaces en silicium (Si/Si).

Les conditions opératoires sont les mêmes que celles de l'exemple 1 à l'exception de la pression à l'intérieur de l'enceinte lors des étapes de traitement de surface qui est soit de 40 mT ou soit de 60 mT.

Les résultats obtenus sont présentés dans le tableau 3.

**Tableau 3**

| Durée de stockage (h) | | 12 | 24 | 36 | 48 |
|---|---|---|---|---|---|
| Energie de collage (J/m²) | 40mT | 2,9 | 3,6 | 5 | 5 |
| | 60 mT | 3,8 | 4,9 | 5 | 5 |

Dans un réacteur ICP, une pression de 60 mT lors des étapes de traitement de surface permet l'obtention d'une énergie de collage de 5 J/m² dès 24h de stockage tandis qu'une telle énergie de collage n'est obtenue qu'après 36h de stockage lorsque la pression lors des étapes de traitement de surface est de 40 mT.

### Exemple 4: Procédé de collage de surfaces en silicium en fonction des puissances de la source plasma et du bias lors des traitements de surface

Les collages sont réalisés entre deux surfaces en silicium (Si/Si).

Les conditions opératoires sont les mêmes que celles de l'exemple 1 à l'exception des puissances de la source plasma et du bias lors des traitements de surfaces qui sont soit de 400 et 10W respectivement, soit de 800 et 20W respectivement.

Les résultats obtenus sont présentés dans le tableau 4.

**Tableau 4**

| Durée de stockage (h) | | 12 | 24 | 36 | 48 |
|---|---|---|---|---|---|
| Energie de collage (J/m²) | 400/10 W | 2,9 | 3,6 | 5 | 5 |
| | 800/20 W | 3,2 | 3,6 | 4,1 | 5 |

Dans un réacteur ICP, des puissances de la source de plasma et du bias élevées (respectivement 800 et 20W) lors des étapes de traitement de surface permettent l'obtention d'une énergie de collage de 5 j/m² après un stockage de plus longue durée que lorsque ces mêmes puissances sont plus basses (respectivement 400 et 10W).

### Exemple 5 : Procédé de collage de surfaces en silicium en fonction du pourcentage de dilution en volume du chlore dans l'oxygène du plasma du traitement d'activation de surface

Les collages sont réalisés entre deux surfaces en silicium (Si/Si).

Les conditions opératoires sont les mêmes que celles de l'exemple 1 à l'exception du pourcentage de dilution en volume du chlore dans l'oxygène du plasma du traitement d'activation de surfaces qui est dans un cas de 3% et dans l'autre cas de 6%.

Les résultats obtenus sont présentés dans le tableau 5.

**Tableau 5**

| Durée de stockage (h) | | 12 | 24 | 36 | 48 |
|---|---|---|---|---|---|
| Energie de collage (J/m²) | 3% | 2,9 | 3,6 | 5 | 5 |
| | 6% | 2,6 | 2,9 | 3,2 | 3,6 |

Lors d'un collage de deux surfaces Si/Si, l'augmentation du pourcentage de dilution en volume du chlore dans l'oxygène du plasma du traitement d'activation de surface de 3 à 6% ne permet pas d'améliorer l'énergie de collage.

### Exemple 6 : Procédé de collage de surfaces à base de silicium en fonction de la présence de brome dans le plasma du traitement d'activation de surface

Les collages sont réalisés entre deux surfaces en SiO₂ (SiO₂/SiO₂) de 145 nm d'épaisseur.

Dans un premier cas, les conditions opératoires sont les mêmes que celles de l'exemple 1 (plasma O₂/Cl₂). Dans un second cas (noté « plasma O₂/HBr/Cl₂ ») les conditions opératoires sont les mêmes que celles de l'exemple 1 à l'exception de la présence de HBr dans le plasma du traitement d'activation, le pourcentage de dilution en volume du brome dans l'oxygène du plasma étant de 4,55%.

Les résultats obtenus sont présentés dans ce même tableau 6.

**Tableau 6**

| Durée de stockage (h) | | 12 | 24 | 36 | 48 |
|---|---|---|---|---|---|
| Energie de collage (J/m²) | Plasma O₂/Cl₂ | 1,9 | 2,3 | 3,6 | 3,6 |
| | Plasma O₂/HBr/Cl₂ | 2,6 | 3,6 | - | 4,6 |

Lors d'un collage de deux surfaces SiO₂/SiO₂, la présence de brome dans le plasma du traitement d'activation de surface permet d'augmenter l'énergie de collage entre les deux surfaces en contact.

De plus, pour tous les collages formés selon les exemples 1 à 6, l'analyse du spectre réalisé par spectroscopie infrarouge à transformée de Fourrier (FTIR) d'un collage O₂/Cl₂ de deux surfaces à base de silicium selon le mode opératoire décrit par C. Wang et T. Suga ("Room-temperature direct bonding using fluorine containing plasma activation", J. Electrochem. Soc. 2011, 158(5):H529) a révélé l'obtention d'interfaces de collage substantiellement sans défaut.

D'autres essais ont également été réalisés dans un dispositif RIE. Le traitement d'activation a été réalisé à température ambiante, c'est-à-dire à 25 ± 5°C, sous une pression partielle comprise entre 40mT et 200 mT pendant une durée comprise entre 15 et 90 secondes. La puissance de la source plasma est fixée entre 100 et 400 W. Le pourcentage de dilution en volume du chlore dans l'oxygène du plasma O₂ / Cl₂ a été fixé entre 0,25 et 10%. Ces essais ont également permis d'obtenir des collages de forte énergie substantiellement sans défaut.

## Revendications

1. Procédé de collage de deux surfaces à base de silicium, **caractérisé en ce qu'**il comprend les étapes successives suivantes:
- soumettre l'une au moins des surfaces à un traitement d'activation de surface au moyen d'un plasma oxygène comprenant du chlore, le pourcentage de dilution en volume du chlore dans l'oxygène du plasma étant de 0,25 à 10%, préférentiellement 1 à 3%,
- mettre en contact les surfaces traitées.

2. Procédé selon la revendication 1, **caractérisé en ce que** les surfaces sont choisies parmi le silicium, les oxydes de silicium, le silicium-germanium, l'oxycarbure de silicium et le nitrure de silicium.

3. Procédé selon la revendication 1 ou 2, **caractérisé en ce que**, préalablement au traitement d'activation de surface, les surfaces sont soumises à un traitement d'oxydation de surface au moyen d'un plasma oxygène dépourvu de chlore.

4. Procédé selon l'une quelconque des revendications précédentes, **caractérisé en ce que** le plasma du traitement d'activation de surface comprend un gaz additionnel choisi parmi le brome, l'argon, l'azote, le fluor ou un mélange de ceux-ci.

5. Procédé selon la revendication 4, **caractérisé en ce que** le plasma du traitement d'activation de surface comprend du brome, le pourcentage de dilution en volume du brome dans l'oxygène du plasma étant dé 0,25 à 10%, préférentiellement de 2 à 5%.

6. Procédé selon l'une quelconque des revendications précédentes, **caractérisé en ce qu'**au moins un traitement d'activation de surface est réalisé à une pression de 5 à 200 mT, préférentiellement de 30 à 80 mT, plus préférentiellement encore de 50 à 70 mT.

7. Procédé selon l'une quelconque des revendications précédentes, **caractérisé en ce que** le plasma d'au moins un traitement d'activation de surface est généré par une source d'une puissance de 200 à 1000 W, préférentiellement de 300 à 500 W.

8. Procédé selon la revendication 7, **caractérisé en ce que** la durée du traitement d'activation de surface est comprise entre 10 et 120 secondes, préférentiellement entre 20 et 40 secondes.

9. Procédé selon l'une quelconque des revendications précédentes, **caractérisé en ce qu'**il comprend, après la mise en contact des surfaces traitées, une étape de traitement thermique à une température de 80 à 200°C, préférentiellement de 80 à 120°C.

10. Procédé selon la revendication 9, caractérisé en ce l'étape de traitement thermique est réalisée pendant une durée de 30 à 120 minutes, préférentiellement de 45 minutes à 75 minutes.
